# EUROPÄISCHE PATENTSCHRIFT

(11) **EP 1 267 484 B1**
(45) Veröffentlichungstag und Bekanntmachung des Hinweises auf die Patenterteilung: **04.06.2008**
(21) Anmeldenummer: 01440167.3
(22) Anmeldetag: 14.06.2001
(51) Int. Cl.: H03F 1/32

(54) **Verfahren und Vorrichtung zur Vorverzerrung eines Sendesignals**
Circuit and method for providing a RF signal with pre-distortion
Circuit et méthode pour pré-distordre un signal radiofréquence

(43) Veröffentlichungstag der Anmeldung: 18.12.2002
(73) Patentinhaber: Alcatel Lucent, 75008 Paris (FR)
(72) Erfinder: Bauernschmitt, Rüdiger, DR. Rer. Nat., 71665 Vaihingen (DE); Wölfle, Gerd, Dr., 71116 Gärtringen (DE)
(74) Vertreter: Brose, Gerhard

(56) Entgegenhaltungen:
- WO-A-00/72438
- US-A- 4 882 547
- US-A- 5 524 285

## Beschreibung

Die Erfindung betrifft ein Verfahren zur Vorverzerrung eines Sendesignals gemäß dem Oberbegriff des Anspruch 1. Außerdem betrifft die Erfindung Vorrichtungen zur Durchführung des Verfahrens, nämlich einen Sender, eine damit ausgestattete Sendestation sowie ein damit aufgebautes Nachrichtenübertragungssystem nach dem Oberbegriff eines der nebengeordneten Ansprüche.

Bei der Erzeugung eines Sendesignales in einem Sender, insbesondere bei der Modulation mit einer nicht-konstanten Hüllkurve, sowie bei der Leistungsverstärkung des Sendesignales, bewirkt das nicht lineare Verhalten der Baugruppen unerwünschte Verzerrungen des Sendesignales, die zu einer Verschlechterung der Sendesignalqualität führen. Um diesem Problem entgegen zu wirken, kommen üblicherweise Linearisierungsverfahren zur Anwendung.

Aus der US-A-5,892,397 ist ein Funksender bekannt, der einen Leistungsverstärker enthält und eine vorgeschaltete Vorverzerrerstufe, die das Sendesignal entsprechend veränderbarer Koeffizienten (weigthing coefficient) vorverzerrt. Die Koeffizienten werden in Abhängigkeit von der am Ausgang des Leistungsverstärkers gemessenen Spektralleistung (s. dort Spalte 2, Zeilen 7-19) mit einem geeigneten Verfahren optimiert. Es wird in einem Frequenzbereich außerhalb des eigentlichen Übertragungsbands gemessen, so dass die dort gemessene Spektralleistung einen Fehlerwert repräsentiert (s. Spalte 6, Zeilen 57-66). Die Vorverzerrung selbst wird am Eingang des Leistungsverstärkers, d.h. in der Hochfrequenzlage, durchgeführt (s. dort Spalte 3, Zeilen 23-34). Dieses bekannte Verfahren und die ausführende Sendevorrichtung lösen das Problem der Signalverzerrung nicht vollständig, denn die Vorverzerrung direkt am Eingang des Leistungsverstärkers wirkt nicht auf die davor liegenden Baugruppen, zu denen etwa Leistungsteiler oder Modulationsstufe gehören.

WO 00 172 438 offenbart einen Leistungsverstärker bei dem das Eingangssignal im Basisband digital vorverzerrt wird und bei dem das Ausgangssignal über ein Bandpassfilter der Linearisierungseinheit zugeführt wird.

Aufgabe der Erfindung ist es, ein verbessertes Verfahren zur Vorverzerrung eines Sendesignals vorzuschlagen, bei dem nach Möglichkeit die in allen Baugruppen auftretenden Verzerrungen kompensiert werden, wobei ein besonders gut geeignetes Rückkopplungssignal genutzt werden soll. Außerdem sollen ein nach dem Verfahren arbeitender Sender zum Senden des Sendesignals, eine Sendestation sowie ein Nachrichtenübertragungssystem vorgeschlagen werden.

Gelöst wird die Aufgabe durch ein Verfahren mit den Merkmalen des Anspruch 1 und durch einen Sender, eine Sendestation sowie ein Nachrichtenübertragungssystem mit den Merkmalen nach einem der nebengeordneten Ansprüche.

Demnach wird das Sendesignal, bevor es in die Hochfrequenzlage umgesetzt wird, in der Basisbandlage mittels digitaler Signalverarbeitungsmittel digital vorverzerrt. Die Vorverzerrung wird gesteuert durch ein rückgekoppeltes Signal, das erzeugt wird, indem von einem Detektor die Spektralleistung des Sendesignals in der Hochfrequenzlage gemessen wird, sowohl innerhalb eines ersten Frequenzbereichs, der in dem Sendespektrum liegt, als auch innerhalb eines zweiten Frequenzbereichs, der außerhalb des Sendespektrum liegt. Die digitale Vorverzerrung ist flexibel parametrisiert und wird durch die rückgekoppelte Steuerung an das aktuelle Verhalten der Senderbaugruppen angepasst. Dadurch, dass der Detektor sowohl im Übertragungsband als auch, vorzugsweise gleichzeitig, außerhalb dieses Übertragungsbandes misst, kann als Steuerungsparameter die momentane Leistung der Intermodulationsprodukte des Senders in benachbarten Kanälen gemessen werden. Dieser Steuerungsparameter ist besonders gut geeignet, die Vorverzerrung des Sendesignals zu optimieren.

Besonders vorteilhafte Ausgestaltungen der Erfindung ergeben sich aus den Unteransprüchen.

Die Erfindung und die sich daraus ergebenden Vorteile werden nun anhand eines Ausführungsbeispiels näher beschrieben, wobei auf die folgenden schematischen Darstellungen Bezug genommen wird:
- Fig. 1,: die das Ablaufdiagramm für ein erfindungsgemäßes Verfahren zeigt;
- Fig. 2a u. b,: die den Aufbau eines Funksenders zeigt, der nach diesem Verfahren arbeitet; und

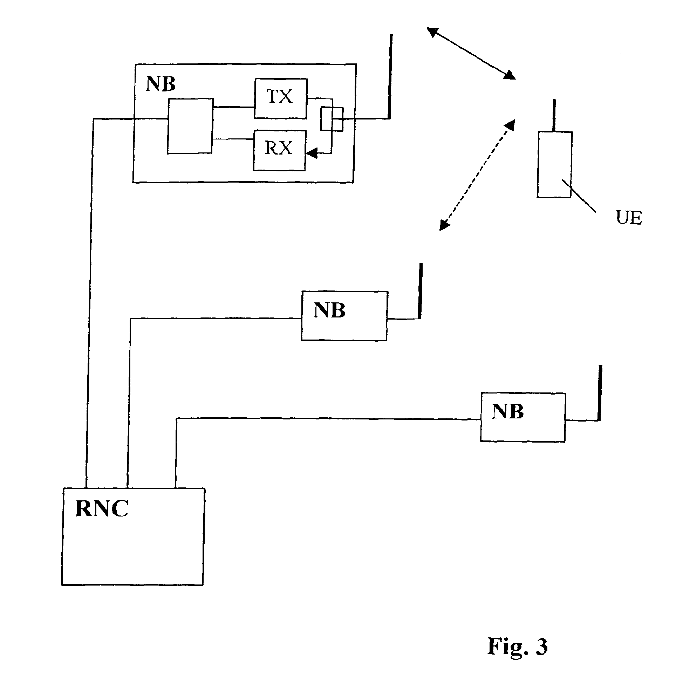

- Fig. 3,: die ein drahtloses Nachrichtenübertragungssystem zeigt, das mit solchen Funksendern ausgestattet ist.

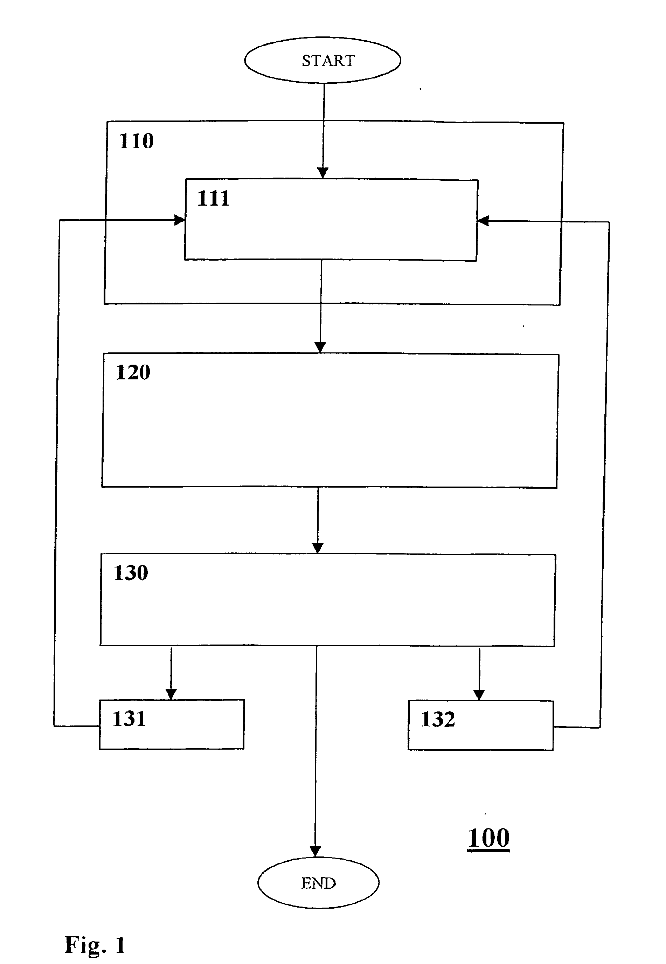

In der Figur 1 ist das Ablaufdiagramm für ein Verfahren 100 dargestellt, mit dem ein Sendesignal in einem Sender vorverzerrt wird. Das Verfahren enthält die Schritte 110 bis 132 und wird folgendermaßen durchgeführt:

Nach dem Start des Verfahrens wird in einem ersten Schritt 110 das Sendesignal vorverzerrt. Die Vorverzerrung erfolgt in der Basisbandlage und wird digital ausgeführt, wobei später beschriebene Steuerparameter berücksichtigt werden (Schritt 111). Nachdem das Sendesignal vorverzerrt wurde, wird es aus der Basisbandlage hochgemischt in die Hochfrequenzlage. Dies erfolgt in dem nächsten Schritt 120, den eine Mischstufe ausführt. Anschließend wird in einem Schritt 130 das hochgemischte Signal verstärkt. Dies wird durch einen Leistungsverstärker durchgeführt, der das verstärkte Signal in eine Antenne einspeist und aussendet. Von dem ausgesendeten Signal werden zwei Messproben wie folgt genommen:

In einem ersten Teilschritt 131 wird die Spektralleistung des ausgesendeten Signals detektiert und zwar innerhalb eines bandpassbegrenzten Frequenzbereiches, der sich in dem Übertragungsband befindet. In einem anderen vorzugsweise gleichzeitig ausgeführten Teilschritt 132 wird die Spektralleistung in einem zweiten bandpassbegrenzten Frequenzbereich detektiert, der außerhalb des Übertragungsbandes liegt. Es werden also am Ausgang des Leistungsverstärkers zwei Messwerte gewonnen, von denen der eine die Leistungsdichte innerhalb des Übertragungsbandes und der andere die Leistungsdichte außerhalb des Übertragungsbandes repräsentiert. Diese Messwerte werden zurückgekoppelt an die im Schritt 111 durchgeführte Vorverzerrung und dienen als Steuerungsparameter zu deren Optimierung. Der Unterschied zwischen der innerhalb des Übertragungsbandes gemessenen Leistung und derjenigen außerhalb des Übertragungsspektrums gemessenen Leistung ist eine Größe, die kurz mit ACP-Wert (adjacent channel leakage power) bezeichnet wird. Der ACP-Wert repräsentiert eine Leistung der aufgrund der Nichtlinearität des Senders auftretenden Intermodulationsprodukte. Es ist also die Leistung, die aufgrund von Intermodulationsprodukten in den Nachbarkanälen abgestrahlt wird. Mit Hilfe des ermittelten ACP-Wertes kann nun die digitale Vorverzerrung optimiert werden, so dass möglichst wenig Verlust am Ausgang des Senders entsteht.

Die in den Schritten 131 und 132 ermittelten Messwerte werden vorzugsweise dadurch gewonnen, dass das Sendesignal aus der Hochfrequenzlage heruntergemischt wird in eine Zwischenfrequenzlage. Durch Veränderung der Frequenz des Lokaloszillators am Mischer kann über das ganze Spektrum hinweg die Spektralleistung des Sendesignales gemessen werden. Es ist also möglich das gesamte Spektrum abzutasten (scanning). Diese Vorgehensweise ist besonders gut geeignet für breitbandige Sendevorrichtungen, insbesondere für

Mehrträgersendevorrichtungen (multi carrier transmitter), da die Bandbreite des zur Messung herangezogenen bandpassbegrenzten Signals nicht im gleichen Maße ansteigt wie die Bandbreite des eigentlichen Sendesignals.

Das beschriebene Verfahren 100 ist grundsätzlich in jedem Sender anwendbar, der nichtlineare Baugruppen, insbesondere Leistungsverstärker, enthält. In dem hier beschriebenen Ausführungsbeispiel wird jedoch bevorzugt die Anwendung bei Funksendern, insbesondere bei Mobilfunksendern, genannt, die mit einer besonders hohen Dynamik Funksignale über ein breitbandiges Spektrum hinweg aussenden. Als Beispiel werden hier die Funksender für das zukünftige Mobilfunksystem UMTS genannt, wo breitbandige codegespreizte Funksignale erzeugt werden.

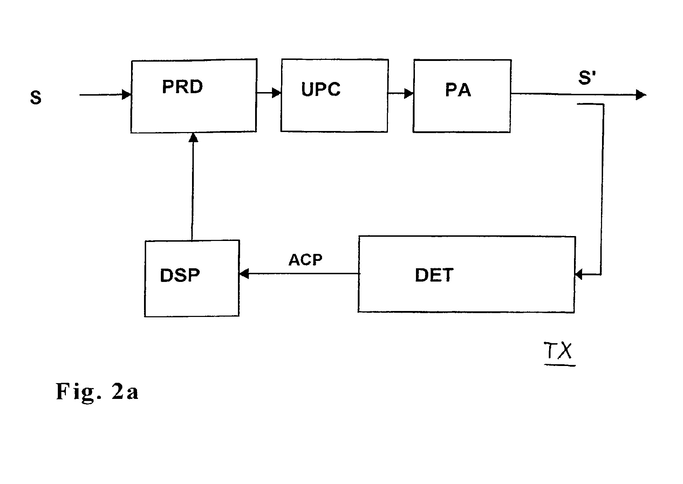

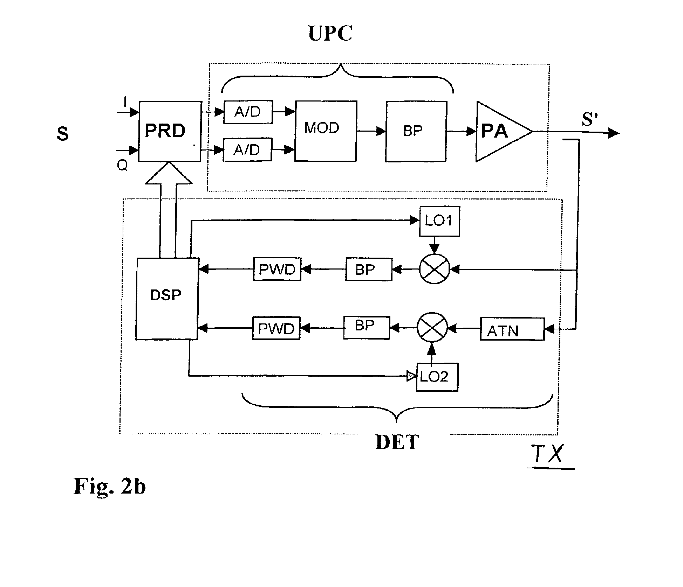

Die Figuren 2a und b zeigen Blockschaltbilder für einen erfindungsgemäßen Sender TX, wobei die Figur 2a das allgemeine Blockschaltbild des Senders und die Figur 2b den detaillierteren Aufbau des Senders zeigen.

Der in der Figur 2a dargestellte Sender TX hat eine Vorverzerrerstufe PRD, eine nachgeschaltete Mischstufe UPC und einen nachgeschalteten Leistungsverstärker PA. Das am Eingang der Vorverzerrerstufe PRD eingespeiste Sendesignal S wird zunächst in der Basisbandlage vorverzerrt, dann hochgemischt in die Hochfrequenzlage und anschließend leistungsverstärkt ausgesendet als Sendesignal S' über eine nicht dargestellte Antenne. Der Sender TX enthält außerdem einen Detektor DET, dessen Eingang über einen Richtkoppler mit dem Ausgang des Leistungsverstärkers verbunden ist, und einen dem Detektor nachgeschalteten digitalen Signalprozessor, der mit dem Steuereingang der Vorverzerrrerstufe PRD verbunden ist. Der Detektor DET und der Signalprozessor DSP sind die wesentlichen Bestandteile einer Rückkopplungsschleife, die dazu dient die Vorverzerrung in der Stufe PRD zu steuern. Der Detektor führt dazu Messungen des Sendesignales S' durch und bildet ein rückgekoppeltes Signal ACP, das die Leistung der im Sender entstandenen Intermodulationsprodukte angibt, also gewissermaßen den Verlust im Sendespektrum des Signales S' angibt.

Der genauere Aufbau des Senders ist in der Figur 2b dargestellt. Wie dort zu sehen ist, wird in der Basisbandlage das Sendesignal S in Form seiner Quadraturkomponente I und Q zur Vorverzerrerstufe PRD übertragen. Die digitalen Ausgangssignale der Vorverzerrerstufe PRD werden anschließend zu analogen Signalen gewandelt und in einem IQ-Modulator MOD auf den Hochfrequenzträger moduliert. Ein nachgeschalteter Bandpass BP begrenzt das Hochfrequenzsendesignal bevor es in den Leistungsverstärker PR eingespeist wird. Das verstärkte Sendesignal S' wird dann in die Sendeantenne eingespeist.

Die dem Leistungsverstärker PA vorgeschalteten Baugruppen, insbesondere der Modulator MOD, bilden Bestandteile der Mischstufe UPC. Der Rückkopplungskanal mit dem Detektor DET und dem digitalen Signalprozessor DSP ist folgendermaßen aufgebaut:

Der Detektor DET enthält im wesentlichen zwei Signalpfade, einen für eine Messung innerhalb des Übertragungsbandes und einen für eine Messung außerhalb des Übertragungsbandes. Ausgehend von dem Richtkoppler am Ausgang des Leistungsverstärkers PA geht der erste rückgekoppelte Signalpfad auf einen ersten Mischer, der einen ersten Lokaloszillator LO1 enthält. Der zweite Signalpfad geht parallel dazu zunächst auf ein Dämpfungsglied ATN und anschließend auf einen zweiten Mischer, der mit einem zweiten Lokaloszillator LO2 heruntermischt. Die Ausgänge der Mischstufen sind jeweils mit einem Bandpass verbunden, der das Ausgangssignal auf einen schmalen Frequenzbereich beschränkt. Die beiden Lokaloszillatoren LO1 und LO2 sind so abgestimmt, dass dieser Frequenzbereich im ersten Pfad einem Spektralbereich außerhalb des eigentlichen Sendespektrums und im zweiten Pfad einem Spektralbereich innerhalb des eigentlichen Sendespektrums entspricht. Die bandpassbegrenzten Signale werden dann auf Leistungsmessstufen PBD geführt, die die Spektralleistung des Sendesignales S' außerhalb des Übertragungsbandes (erster Signalpfad mit LO1) und innerhalb des Übertragungsbandes (zweiter Signalpfad mit LO2) messen. Die Messwerte werden dann dem digitalen Signalprozessor DSP zugeführt, der wiederum über einen Steuerbus die Vorverzerrerstufe PRD steuert. Der Signalprozessor DSP übermittelt also an die Vorverzerrerstufe PRD die von ihm selektierten und optimierten Parameter.

Die in den Figuren 2a und b dargestellten Blockschaltbilder zeigen nur eine Möglichkeit der Realisierung eines erfindungsgemäßen Senders. So könnte z.B. die Vorverzerrerfunktion (PRD-Funktion) zusammen mit der Steuerungsfunktion (DSP-Funktion) in einer Einheit, vorzugsweise in einem FPGA oder ASIC, implementiert werden. Es ist auch denkbar, dass anstelle von zwei parallel geführten Signalpfaden lediglich ein Signalpfad mit einer Mischstufe verwendet wird, die abwechselnd mit der ersten oder der zweiten Mischfrequenz das Sendesignal heruntermischt. Jedoch ist es vorteilhaft wenn gleichzeitig mit beiden Zwischenfrequenzen das Sendesignal sowohl innerhalb des Übertragungsbandes als auch außerhalb des Übertragungsbandes gemessen wird. Dadurch kann exakt die momentane Intermodulationsleistung Senders bezogen auf die Ausgangsleistung berechnet werden. Durch die in der Zwischenfrequenzlage vorgenommenen Messungen ist es möglich jeden Teilbereich des Spektrums durch entsprechendes Verstellen der Oszillatoren LO1 und LO2 zu untersuchen. Daher kann die gesteuerte Vorverzerrung schnell an die gegebenen Erfordernisse, insbesondere an die Übertragungsverfahren und Trägerfrequenzschemata, angepasst werden. Die Erfindung ist besonders gut geeignet zur Leistungssteuerung in hochdynamischen Sendern, insbesondere in Funksendevorrichtungen und opto-elektronischen Sendevorrichtungen.

## Patentansprüche

1. Verfahren (100) zur Vorverzerrung eines Sendesignals in einem Sender, der einen Leistungsverstärker enthält, mit den folgenden Schritten:
- das Sendesignal wird vorverzerrt (Schritt 110),
- das Sendesignal wird in der Hochfrequenzlage mittels des Leistungsverstärkers verstärkt und ausgesendet (Schritt 130),
**dadurch gekennzeichnet, dass**
das Sendesignal in der Basisbandlage digital vorverzerrt wird (Schritt 110) und anschließend in die Hochfrequenzlage hochgemischt wird (Schritt 120), wobei die digitale Vorverzerrung des Sendesignals durch ein rückgekoppeltes Signal gesteuert wird (Schritt 111), das von einem Detektor erzeugt wird, indem von dem Detektor die Spektralleistung des Sendesignals in der Hochfrequenzlage gemessen wird sowohl innerhalb eines ersten Frequenzbereichs, der in dem Sendespektrum liegt, als auch innerhalb eines zweiten Frequenzbereichs, der außerhalb des Sendespektrums liegt (Schritte 131 und 132).

2. Verfahren (100) nach Anspruch 1, **dadurch gekennzeichnet, dass** die Spektralleistung des Sendesignals innerhalb des ersten Frequenzbereichs gemessen wird (Schritt 131) und gleichzeitig innerhalb des zweiten Frequenzbereichs gemessen wird (Schritt 132).

3. Verfahren nach Anspruch 1, **dadurch gekennzeichnet, dass** das der erste und zweite Frequenzbereich jeweils mittels eines Bandpassfilters begrenzt wird und dass die Spektralleistung in diesen Frequenzbereichen gemessen wird mittels Heruntermischen des Sendesignals von der Hochfrequenzlage in eine Zwischenfrequenzlage, wobei die Frequenz des im Mischer verwendeten Lokaloszillators veränderlich ist, so dass im gesamten Sendesignalband gemessen werden kann.

4. Sender (TX) zum Aussenden eines Sendesignals (S, S') mit einer Vorverzerrerstufe (PRD), die das Sendesignal (S) vorverzerrt, und mit einem nachgeschalteten Leistungsverstärker (PA), der das Sendesignal (S') in der Hochfrequenzlage zum Aussenden verstärkt,
**dadurch gekennzeichnet, dass**
der Sender (TX) eine der Vorverzerrerstufe (PRD) nachgeschaltete und dem Leistungsverstärker (PA) vorgeschaltete Mischstufe (UPC) enthält, die das vorverzerrte Sendesignal (S') in die Hochfrequenzlage hochmischt, dass die Vorverzerrerstufe (PRD) Signalverarbeitungsmittel enthält , die das Sendesignal (S) digital vorverzerren, und dass mit dem Ausgang des Leistungsverstärkers (PA) ein Detektor (DET) verbunden ist, der zur Steuerung der Signalverarbeitungsmittel der Vorverzerrerstufe (PRD) ein rückgekoppelte Signal (APC) erzeugt, indem er die Spektralleistung des Sendesignals (S') in der Hochfrequenzlage misst sowohl innerhalb eines ersten Frequenzbereichs, der in dem Sendespektrum liegt, als auch innerhalb eines zweiten Frequenzbereichs, der außerhalb des Sendespektrum liegt.

5. Sendestation (NB) mit einem Sender (TX) nach Anspruch 4 zum Aussenden eines Sendesignals (S, S').

6. Nachrichtenübertragungssystem (UMTS), das mindestens eine Sendestation (NB) nach Anspruch 5 enthält.

## Claims

1. Method (100) for pre-distorting a transmission signal In a transmitter which contains a power amplifier with the following steps:
- the transmission is pre-distorted (step 110)
- the transmission signal is amplified in the high frequency state by means of the amplifier and is transmitted (step 130),
**characterised in that**
the transmission signal is pre-distorted digitally in the base band state (step 110) and then forwarded to the high frequency state (step 120), whereby the digital pre-distortion of the transmission signal is controlled by a fed back signal (step 111) which is generated by a detector, **in that** the detector measures the spectrum capacity of the transmission signal in the high frequency state both within a first frequency range which is in the transmission spectrum and within a second frequency range which is outside the transmission range (steps 131 and 132).

2. Method (100) according to claim 1 **characterised in that** the spectrum capacity of the transmission signal is measured within the first frequency range (step 131) and is measured at the same time within the second frequency range (step 132).

3. Method according to claim 1 **characterised in that** the first and second frequency ranges are limited in each case by means of a bandpass filter and that the spectrum capacity is measured in these frequency ranges by means of mixing down the transmission signal from the high frequency state into an Interim frequency state, where by the frequency of the local oscillator used in the mixer can be changed so that measurement can be carried out throughout the transmission signal band.

4. Transmitter (TX) for the transmission of a transmission signal (S, S') with a pre-distorter stage (PRD) which pre-distorts the transmission signal (S) and with a downstream capacity amplifier (PA) which amplifies the transmission signal (S') in the high frequency state for transmission,
**characterised in that**
the transmitter (TX) contains a mixer stage (UPC) after the pre-distorter stage (PRD) and the capacity amplifier (PA) which mixes the pre-distorted transmission signal (5') to the high frequency state, and that the pre-distorter stage (PRD) contains signal processing means that digitally distort the transmission signal (S), and that the output of the capacity amplifier (PA) is connected to a detector (DET), which generators a fed back signal (APC) to control the signal processing means of the pre-distorter stage (PRD), **in that** it measures the spectrum capacity of the transmission signal (S') in the high frequency state both inside a first frequency range which lies inside the transmission range and within a second frequency range which lies outside the transmission range.

5. Transmitter station (NB) with a transmitter (TX) according to claim 4 for the transmission of a transmission signal (S, S').

6. Message transmission system (UMTS) which contains at least one transmitter station (NB) according to claim 5.

## Revendications

1. Procédé (100) permettant d'effectuer une prédistorsion d'un signal d'émission dans un émetteur qui contient un amplificateur de puissance, comportant les étapes suivantes :
- le signal d'émission est soumis à une prédistorsion (étape 110),
- le signal d'émission est amplifié et émis dans la couche haute fréquence au moyen de l'amplificateur de puissance (étape 130),
**caractérisé en ce que**
le signal d'émission est soumis à une prédistorsion numérique dans la couche bande de base (étape 110) et par la suite soumis à un mélange ascendant dans la couche haute fréquence (étape 120), moyennant quoi la prédistorsion numérique du signal d'émission est commandée par un signal réinjecté (étape 111) qui est produit par un détecteur, pendant que la puissance spectrale du signal d'émission est mesurée par le détecteur dans la couche haute fréquence aussi bien dans une première zone de fréquence qui se trouve dans le spectre d'émission, que dans une seconde zone de fréquence qui se trouve en dehors du spectre d'émission (étapes 131 et 132).

2. Procédé (100) selon la revendication 1, **caractérisé en ce que** la puissance spectrale du signal d'émission est mesurée dans la première zone de fréquence (étape 131) et mesurée en même temps dans la seconde zone de fréquence (étape 132).

3. Procédé selon la revendication 1, **caractérisé en ce que** la première et la seconde zones de fréquence sont limitées respectivement au moyen d'un filtre passe-bande et **en ce que** la puissance spectrale est mesurée dans ces zones de fréquence au moyen d'un mélange descendant du signal d'émission de la couche haute fréquence dans une couche fréquence intermédiaire, moyennant quoi la fréquence de l'oscillateur local utilisée dans le mélangeur est variable, de sorte qu'on puisse mesurer dans l'ensemble de la bande de signal d'émission.

4. Émetteur (TX) permettant d'émettre un signal d'émission (S, S') comportant un étage de prédistorsion (PRD), qui effectue une prédistorsion du signal d'émission (S), et un amplificateur de puissance monté en aval (PA) qui amplifie le signal d'émission (S') dans la couche haute fréquence en vue de son émission,
**caractérisé en ce que**
l'émetteur (TX) contient un étage de mélange (UPC) monté en aval de l'étage de prédistorsion (PRD) et monté en amont de l'amplificateur de puissance (PA), qui effectue un mélange ascendant du signal d'émission soumis à une prédistorsion (S') dans la couche haute fréquence, l'étage de prédistorsion (PRD) contient des moyens de traitement des signaux qui effectuent une prédistorsion numérique du signal d'émission (S), et **en ce qu'**un détecteur (DET) est relié à la sortie de l'amplificateur de puissance (PA) qui produit un signal réinjecté (APC) en vue de la commande des moyens de traitement des signaux de l'étage de prédistorsion (PRD), pendant qu'il mesure la puissance spectrale du signal d'émission (S') dans la couche haute fréquence aussi bien dans une première zone de fréquence qui se trouve dans le spectre d'émission, que dans une seconde zone de fréquence qui se trouve en dehors du spectre d'émission.

5. Station émettrice (NB) comportant un émetteur (TX) selon la revendication 4 permettant d'émettre un signal d'émission (S, S').

6. Système de transmission de messages (UMTS) qui contient au moins une station émettrice (NB) selon la revendication 5.
